# FASCICULE DE BREVET EUROPEEN

(11) **EP 2 098 105 B1**
(45) Date de publication et mention de la délivrance du brevet: **28.03.2012**
(21) Numéro de dépôt: 07857387.0
(22) Date de dépôt: 11.12.2007
(51) Int. Cl.: H05K 7/20, H05K 7/14

(54) **BOITIER D'APPAREILLAGE ELECTRONIQUE A REFROIDISSEMENT PAR VENTILATION NATURELLE ET FORCEE**
MITTELS NATÜRLICHER UND ZWANGSBELÜFTUNG GEKÜHLTES GEHÄUSE EINES ELEKTRONISCHEN GERÄTS
ELECTRONIC DEVICE HOUSING COOLED BY NATURAL AND FORCED VENTILATION

(30) Priorité: 21.12.2006 FR 0611209
(43) Date de publication de la demande: 09.09.2009
(73) Titulaire: THALES, 92200 Neuilly-sur-Seine (FR)
(72) Inventeur: NEMOZ, Gérard, 94700 Maisons Alfort (FR); BELLIN, Bruno, 91370 Verrieres le buisson (FR); BIETH, Philippe, 91400 Saclay (FR)
(74) Mandataire: Esselin, Sophie
(86) Numéro de dépôt international: PCT/EP2007/063700
(87) Numéro de publication internationale: WO 2008/080776

(56) Documents cités:
- EP-A- 1 175 136
- WO-A-2005/032230
- FR-A1- 2 886 509
- GB-A- 2 145 290
- US-A1- 2007 086 158

## Description

L'invention est relative au refroidissement des équipements électroniques logés dans des boîtiers ou baies placés sur des plates-formes d'accueil disposant d'une circulation forcée d'air de refroidissement pouvant être sujette à des disfonctionnements. Elle concerne notamment, les boîtiers ou baies d'appareillages électroniques embarqués à bord d'aéronef.

Le refroidissement d'un équipement électronique en boîtier s'obtient habituellement en évacuant les calories produites à l'intérieur du boîtier vers l'environnement extérieur au moyen d'un flux d'air éventuellement pulsé, pénétrant dans le boîtier par des orifices de ventilation situés en partie inférieure servant d'embouchures, venant au contact des composants de l'équipement électronique et s'évacuant en partie supérieure du boîtier par des orifices de ventilation servant d'évents. Les possibilités d'évacuation de calories augmentent avec le débit d'air de refroidissement. Dans le cas des normes aéronautiques telles que l'Arinc 600 notamment, le diamètre et le nombre des orifices de ventilation sont contraints de manière à respecter une perte de charge pour un débit d'air normalisé, lui-même fonction de la puissance dissipée. Cette contrainte permet de répartir le flux d'air pulsé entre les différents calculateurs.

Lorsqu'un boîtier d'appareillage électronique sert également de blindage électromagnétique, ce qui est pratiquement toujours le cas pour un équipement embarqué à bord d'un aéronef, l'efficacité du blindage électromagnétique impose en plus un diamètre réduit aux trous de ventilation.

Ces limitations du diamètre et du nombre des trous de ventilation restreignent grandement les possibilités de refroidissement par convection naturelle et obligent très souvent à limiter la plage de température utilisable en cas de perte de la ventilation forcée.

Les équipements électroniques prévus pour être embarqués à bord d'aéronef sont habituellement mis dans des boîtiers pourvus d'orifices de ventilation d'un diamètre et d'un nombre insuffisants pour permettre un refroidissement normal par la seule convection naturelle. Ces boîtiers sont placés sur une boîte de répartition d'air pulsé, une sorte de sommier d'orgue, leur distribuant, à travers leurs orifices de ventilation, un flux d'air de refroidissement sous pression répondant à des spécifications précises, par exemple celles figurant dans le standard ARINC 600 portant sur la configuration des boîtiers et châssis utilisés dans les aéronefs pour loger des équipements électroniques remplaçables également dits "rackables".

Une telle disposition pose le problème, critique sur le plan de la sécurité, de la nécessaire continuité de certaines fonctions assurées par les équipements électroniques en cas de perte du flux d'air pulsé de refroidissement.

En cas de perte du flux d'air pulsé, le refroidissement n'est plus assuré que par une convection naturelle peu efficace en raison de la trop faible section utile des orifices de ventilation limités en diamètre et en nombre : en diamètre par les exigences du blindage électromagnétique et en nombre par la perte de charge imposée par la norme, ainsi qu'en raison du volume d'air extérieur disponible sous les boîtiers réduit à la contenance de la boîte de répartition d'air pulsé. La température des équipements augmente alors notablement, ce qui dégrade leur marge de fonctionnement en température.

La maîtrise de la température de fonctionnement d'un équipement électronique en cas de perte du flux d'air pulsé est la principale limitation rencontrée lorsque l'on cherche à réduire son encombrement et à augmenter ses fonctionnalités par une densification de l'électronique car l'un et l'autre s'accompagnent toujours d'une augmentation de la production de calories au litre.

Pour améliorer le refroidissement d'un boîtier d'appareillage électronique à refroidissement par air pulsé en cas de perte de la ventilation forcée et permettre une augmentation de la compacité et de la densité d'intégration de l'appareillage électronique, la demanderesse a déjà proposé, dans une demande de brevet français déposée le 30 août 2006 sous le N°06 07628, de pourvoir un boîtier d'appareillage électronique d'orifices de ventilation par convection naturelle sur ses parois inférieure et supérieure et de rampes internes de distribution d'air pulsé alimentées en air sous pression par l'intermédiaire d'une boîte de répartition placée à l'arrière et raccordée à une canalisation de circulation d'air sous pression.

La présente invention a pour but d'améliorer le refroidissement par convection naturelle, d'un boîtier d'appareillage électronique en présence de limitation en diamètre et en nombre des possibilités de perçage d'orifices de ventilation naturelle dans ses parois, avec une mise à profit d'une éventuelle ventilation forcée assurée par des rampes internes de distribution d'air pulsé.

Elle a pour objet un boîtier d'appareillage électronique à refroidissement par ventilation naturelle, par la présence d'orifices de ventilation dans les parois du boîtier et ventilation forcée, par air pulsé, comportant au moins un radiateur thermique interne refroidi par ventilations naturelle et forcée, en contact thermique avec un ou des points chauds d'un appareillage électrique placé dans le boîtier, caractérisé en ce que le radiateur thermique interne est placé en contact thermique avec le ou les points chauds par l'intermédiaire d'au moins un collecteur de chaleur raccordé à au moins un conducteur thermique traversant des parois du boîtier et aboutissant à un ou des radiateurs thermiques externes.

Avantageusement, le ou les radiateurs thermiques internes sont dimensionnés pour suffire au refroidissement de l'appareillage électrique placé dans le boîtier en cas de fonctionnement normal de la ventilation forcée tandis que et le ou les radiateurs thermiques externes sont dimensionnés pour compléter le refroidissement apporté par les radiateurs thermiques internes en cas de perte de la ventilation forcée.

Avantageusement, une partie du flux d'air de la ventilation forcée est dirigée sur le ou les radiateurs thermiques externes.

Avantageusement, la ventilation forcée est assurée au moyen de rampes internes de distribution d'air pulsé passant au travers des parois du boîtier et parvenant au niveau du ou des radiateurs thermiques externes.

Avantageusement, lorsque le boîtier d'appareillage électronique comporte des modules amovibles plats disposés dans une baie, côte à côte, sur la tranche, selon un ou des alignements perpendiculaires au fond de la baie, le ou les radiateurs thermiques externes sont fixés à l'extérieur, sur les tranches avant des modules tournées vers le devant de la baie.

Avantageusement, la ventilation forcée d'un radiateur thermique extérieur fixé à la tranche d'un module est obtenue au moyen d'une rampe de distribution d'air pulsé à l'intérieur du module se prolongeant au travers de la tranche avant du module.

Avantageusement, lorsque le boîtier d'appareillage électronique comporte des modules amovibles plats disposés dans une baie, côte à côte, sur la tranche, selon un ou des alignements perpendiculaires au fond de la baie, le ou les radiateurs thermiques externes sont placés dans une ou des cheminées à ventilation naturelle et forcée, fixées à l'extérieur, sur les tranches avant des modules tournées vers le devant de la baie.

Avantageusement, la ventilation forcée d'une cheminées est obtenue au moyen d'une rampe de distribution d'air pulsé à l'intérieur du module se prolongeant au travers de la tranche avant du module vers la base de la cheminée.

Avantageusement, le tirage naturel d'une cheminée est amplifié par un effet Venturi obtenu au moyen de la ventilation forcée.

Avantageusement, la ventilation forcée d'une cheminée est obtenue au moyen d'une rampe de distribution d'air pulsé à l'intérieur du boîtier se prolongeant au travers de la paroi du boîtier par une buse à effet Venturi pénétrant dans la base de la cheminée et délivrant un flux d'air pulsé amplifiant la circulation naturelle de l'air au sein de la cheminée.

Avantageusement, la ventilation naturelle d'une cheminée est amplifiée par un ventilateur d'appoint placé à la base de la cheminée, contre un cloisonnement l'isolant du flux d'air de la ventilation forcée introduit dans la cheminée.

Avantageusement, la ventilation naturelle d'une cheminée est amplifiée par un ventilateur d'appoint fonctionnant en cas de dépassement d'une température de consigne par le ou les radiateurs thermiques externes logés dans la cheminée.

Avantageusement, le ou les conducteurs thermiques sont des caloducs.

Avantageusement, le ou les conducteurs thermiques sont des tiges à base de carbone à conductivité thermique élevée dans le sens longitudinal.

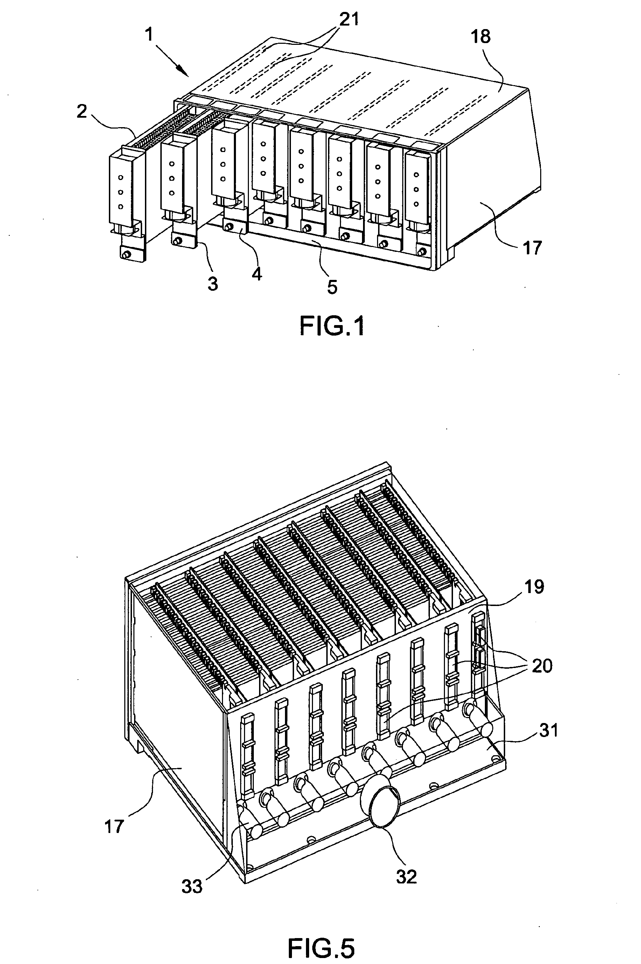

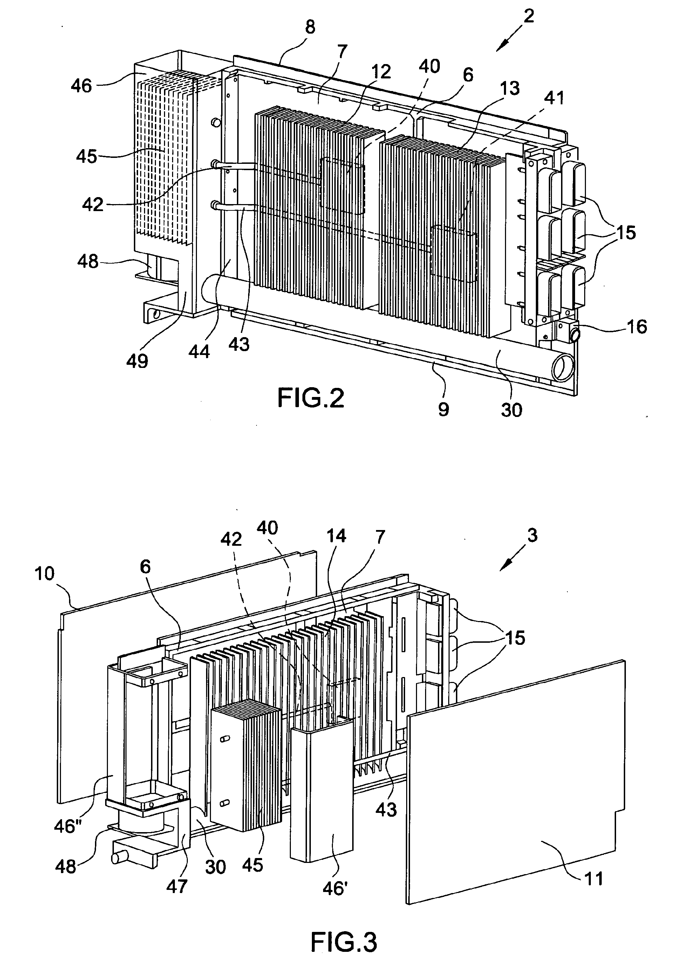

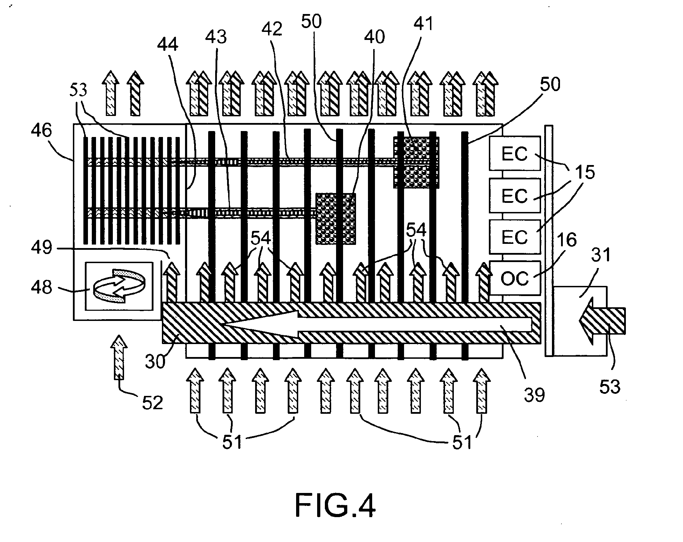

D'autres caractéristiques et avantages de l'invention ressortiront de la description ci-après d'un mode de réalisation donné à titre d'exemple. Cette description sera faite en regard du dessin dans lequel :
- une figure 1 est une vue, en perspective latérale avant, d'une baie électronique pour aéronef, conforme à l'invention, montrée avec des modules ou unités électroniques rackables plus ou moins introduits dans leurs logements respectifs,
- une figure 2 est une vue, en perspective latérale arrière, d'un module de la baie de la figure 1, montré sans son couvercle supérieur,
- une figure 3 est une vue éclatée, en perspective latérale avant, montrant les principaux éléments constituant un module de la baie de la figure 1,
- une figure 4 est une vue schématique d'un module de la baie de la figure 1, représenté de profil, selon une coupe verticale, détaillant les trajets des flux d'air de refroidissement au niveau d'un module, et
- une figure 5 est une vue en perspective latérale arrière de la baie analogue représentée à la figure 1, capot supérieur enlevé, illustrant la disposition d'une boîte de répartition d'air pulsé.

La baie électronique 1 qui va être décrite est destinée à contenir un ensemble modules électroniques 2, 3, 4 dits rackables car enfichables dans un bâti 5 de la baie 1 à la manière de tiroirs.

Les modules électroniques rackables 2, 3, 4 sont de forme rectangulaire plutôt plate. Ils comportent un châssis-cadre 6 supportant une carte de circuit imprimé 7 avec des bords longitudinaux apparents constituant des arêtes longitudinales 8, 9 de guidage, et deux couvercles métalliques 10, 11 assurant une protection physique et électromagnétique de la carte de circuit imprimé 7 et de ses composants.

Les couvercles métalliques peuvent être constitués de cartes de circuits imprimés dont les plans de masse tiennent lieu de blindage.

La carte de circuit imprimé 7 supporte :
- sur l'une de ses faces ou sur ses deux faces, des composants électroniques et/ou optiques non visibles sur les figures ainsi qu'un câblage assurant les interconnexions électriques et/ou optiques des composants supportés,
- sur la ou les faces de montage des composants, un ou plusieurs radiateurs thermiques internes 12, 13, 14 à ailettes, en contact thermique étroit avec les composants électroniques et/ou optiques dégageant des calories et,
- sur l'une de ses faces ou sur ses deux faces, un ensemble de connecteurs électriques 15 et/ou optiques 16 dédiés aux raccordements des modules 2, 3, 4, entre eux et avec l'environnement extérieur à la baie 1.

Les modules électroniques 2, 3, 4 peuvent avoir d'autres conformations à condition qu'ils respectent les contraintes de dimensionnement imposées par la baie 1. Notamment, leurs arêtes longitudinales de guidage 8, 9 peuvent être déportées sur les radiateurs internes 12, 13, 14 à ailettes en contact thermique avec les composants dégageant des calories, en vue d'évacuer une partie des calories dans le châssis de la baie 1 ou sur l'un des couvercles 10, 11.

La baie électronique 1 est pourvue d'un bâti métallique 5 comportant, à la manière habituelle, des parois latérales 17, une paroi inférieure non visible sur les figures, une paroi supérieure 18 et une paroi arrière 19.

Les parois inférieure et supérieure 18 de la baie 1 supportent, en vis à vis, deux réseaux de coulisses parallèles orientées perpendiculairement à la paroi arrière 19 et utilisées pour le guidage des arêtes longitudinales 8, 9 des modules rackables 2, 3, 4 lors des introductions, extractions et maintiens en place des modules 2, 3, 4 côte à côte, sur la tranche, leurs cartes de circuit imprimé 7 orientées dans des plans verticaux perpendiculaires à la paroi arrière 19 de la baie 1.

La paroi arrière 19 de la baie 1 supporte, dans sa partie supérieure, un ensemble 20 de connecteurs de fond de panier s'emboîtant avec le ou les ensembles 15, 16 de connecteurs des cartes de circuits imprimés 7 des modules 2, 3, 4 pour assurer les raccordements des modules 2, 3, 4 entre eux et avec l'environnement extérieur à la baie 1.

Les ailettes des radiateurs thermiques internes 12, 13, 14 des différents modules 2, 3, 4 sont orientées perpendiculairement aux bords longitudinaux des modules 2, 3, 4 de manière à se retrouver en position verticale une fois les modules 2, 3, 4 en place dans la baie 1 et à faciliter leur balayages par des courants ascendants d'air de refroidissement obtenus par convection naturelle et par circulation forcée.

La convection naturelle est due à la présence d'orifices de ventilation 21 dans les parois inférieure et supérieure 18 de la baie 1.

Les orifices de ventilation 21 pratiqués dans les parois inférieure et supérieure 18 de la baie 1 sont constitués de trous de faible diamètre, de l'ordre de 3 millimètres compatibles avec les exigences d'un blindage électromagnétique de la baie 1. Ceux pratiqués dans une paroi intermédiaire, inférieure ou supérieure, prévue pour séparer deux étages de modules, sont de larges fentes longitudinales car la continuité du blindage électromagnétique de la baie 1 n'est pas assurée à ce niveau mais à celui du fond ou du couvercle de la baie 1.

Les orifices de ventilation 21 répartis sur toute la surface de la paroi supérieure 18 de la baie 1, et sur toute la surface de la paroi inférieure constituant le véritable fond de la baie 1, forment des zones grillagées entre les coulisses des réseaux supportant les modules 2, 3, 4 permettant une libre circulation de l'air avec des espaces de dégagement prévus au-dessus et au-dessous de la baie 1.

En plus de la ventilation par convection naturelle, les ailettes des radiateurs thermiques internes des modules 2, 3, 4 sont soumises à une ventilation forcée au moyen de rampes 30 de distribution d'air pulsé alimentées par l'intermédiaire d'une boîte de répartition 31 (figure 5) fixée à l'extérieur de la baie 1, en partie inférieure de sa paroi arrière 19, au-dessous de l'ensemble de connecteurs de fond de panier 20 et raccordée par une embouchure 32, à une conduite d'air sous pression mise à disposition de la baie 1.

Les rampes de distribution d'air pulsé 30 se présentent sous la forme de petites flûtes "piccolo" à pavillon obstrué, dont les trous de jeu servent d'évents latéraux. Elles sont disposées horizontalement, à la base des modules 2, 3, 4 tout au long des radiateurs thermiques internes 12, 13, 14 à ailettes, perpendiculairement à la paroi arrière 19 de la baie 1, avec leurs embouchures individuelles 33 emboîtées dans des orifices de distribution d'air pulsé de la boîte de répartition 31 accessibles depuis l'intérieur de la baie 1 au travers de la paroi arrière 19, et avec leurs évents latéraux soufflant de l'air de refroidissement entre les ailettes des radiateurs thermiques internes 12, 13, 14 des modules 2, 3, 4.

Comme montré sur la figure 3, les rampes de distribution d'air pulsé 30 sont fixées aux radiateurs thermiques internes 12, 13, 14 à ailettes des modules 2, 3, 4 dans des rainures creusées perpendiculairement aux ailettes, à proximité de leurs bases. Leurs évents latéraux, non visibles sur les figures, sont tournés vers les fonds des fentes séparant les ailettes, avec un léger décalage vers le haut pour amorcer et entretenir des courants d'air ascendants. De préférence, les rampes de distribution d'air pulsé 30 sont espacées du fond des rainures 34 pour ne pas faire obstacle aux courants d'air ascendants résultant de la convection naturelle, une amplification, par effet Venturi, de ces courants d'air ascendant étant même recherchée par une orientation adéquate des évents des rampes 30.

Les composants montés sur la carte de circuit imprimé 7 dégageant le plus de calories, par exemples les puces de microprocesseur, sont mis en contact avec les radiateur thermiques internes 12, 13, 14 à ailettes par l'intermédiaire de collecteurs de chaleur 40, 41 raccordés à des conducteurs thermiques 42, 43, par exemple des caloducs ou des tiges à base de carbone à conductivité thermique élevée dans le sens longitudinal, traversant la paroi avant 44 du chassis-cadre 6 d'un module 2, 3, 4 et aboutissant à un radiateur thermique externe 45 placé dans une cheminée 46 fixée extérieurement à la tranche avant d'un module 2, 3, 4.

Comme montré sur les figures 2 et 3, la cheminée 46 renfermant le radiateur thermique externe 45 a ses parois constituées de deux demi-coquilles 46', 46" montées sur des colliers fixés, comme le radiateur thermique externe 45, à la paroi avant 44 du chassis-cadre 6. La base de la cheminée 46 repose sur un support 47 de ventilateur 48 ménageant une chambre intercalaire 49 entre lui et la paroi avant 44 du chassis-cadre 6 . Cette chambre intercalaire 49 débouche dans la base de la cheminée 46 tout en étant isolée du ventilateur 48. La rampe de distribution d'air pulsé 30 assurant la ventilation forcée des radiateurs thermiques internes à ailettes 12, 13, 14, traverse en bout la paroi avant du chassis-cadre 6 pour parvenir dans la chambre intercalaire 49 et insuffler, à la base de la cheminée 46, par une buse ou évent, un courant d'air pulsé amplifiant par effet Venturi le courant d'air naturel provenant, lorsque le ventilateur 48 ne tourne pas, de l'espace laissé libre entre les pales de ce dernier.

La figure 4 illustre la répartition des courants d'air de refroidissement résultant de la convection naturelle et de la distribution d'air pulsé le long des différents radiateurs thermiques d'un module 2, 3, 4.

La convection naturelle provoque une nappe de courants ascendants d'air dé refroidissement repérés par des flèches 51, répartis le long des ailettes 50 des radiateurs thermiques internes 12, 13, 14 ainsi qu'un courant d'air ascendant repéré par une flèche 52, circulant dans la cheminée extérieure 46 le long des ailettes 53 du radiateur thermique externe 45.

Les courants ascendants 51 d'air de refroidissement des radiateurs thermiques internes 12, 13, 14 dus à la convection naturelle, proviennent de l'espace de dégagement prévu sous la baie 1 au travers des multiples orifices de ventilation pratiqués dans le fond de la baie 1 et éventuellement dans des parois intermédiaires inférieures assurant des séparations entre étages, et s'évacuent vers l'espace de dégagement prévu au-dessus de la baie 1 au travers des multiples orifices de ventilation 21 pratiqués dans la paroi supérieure 11 de la baie 1 et éventuellement dans des parois intermédiaires supérieures assurant des séparations entre étages.

Le courant ascendant 52 d'air de refroidissement du radiateur thermique externe 45 dû à la convection naturelle, provient de l'espace laissé libre entre les pales du ventilateur 48, parcourt l'intérieur de la cheminée 46 au contact des ailettes 53 du radiateur thermique externe 45 et s'échappe par le haut de la cheminée 46 sur l'avant de la baie 1.

La distribution d'air pulsé à partir d'une canalisation raccordée depuis l'extérieur de la baie 1 à la boîte de répartition 31, rappelée sur la figure 4 par la flèche 53, provoque une nappe supplémentaire de courants d'air ascendant repérés par des flèches 54, qui sont issus des évents latéraux de la rampe de distribution 30, elle-même parcourue dans le sens de la flèche 39 par de l'air pulsé s'échappant de la boîte de répartition 31, et qui se répartissent le long des ailettes 50 des radiateurs thermiques internes 12, 13, 14. Elle provoque également, en raison de l'évent d'extrémité de la rampe de distribution 30 situé dans la chambre intercalaire 49, une augmentation du tirage de la cheminée 46.

Les radiateurs thermiques internes 12, 13, 14 sont dimensionnés pour suffire au refroidissement de l'appareillage électrique placé dans un module 2, 3, 4 en cas de fonctionnement normal de la ventilation forcée. Le radiateur thermique externe 45 est dimensionné pour compléter le refroidissement apporté par les radiateurs internes en cas de perte de la ventilation forcée. Le ventilateur 48 est déclenché par un thermostat en cas de dépassement d'une température de consigne prise sur la carte 7 ou sur des composants de la carte 7.

Diverses variantes de configuration sont envisageables. Les rampes 30 peuvent être désolidarisées des ailettes des radiateurs thermiques internes ou du chassis-cadre des modules et avoir leurs propres supports de montage, par exemple des clips fixés à la paroi inférieure de la baie 1 entre les glissières. Elles peuvent mêmes être solidaires de la boîte de répartition 31. Leurs évents latéraux peuvent prendre diverses formes y compris celles de fentes. Les cheminées contenant les radiateurs thermiques externes aux modules peuvent former un tout avec les ailettes de ces radiateurs lorsque celles-ci ne sont pas susceptibles d'atteindre des températures dangereuses pour des opérateurs.

## Revendications

1. Boîtier d'appareillage électronique (1) à refroidissement par ventilation naturelle, par la présence d'orifices de ventilation dans les parois du boîtier et ventilation forcée, par air pulsé, comportant au moins un radiateur thermique interne (12, 13, 14) refroidi par ventilations naturelle et forcée, en contact thermique avec un ou des points chauds d'un appareillage électrique placé dans le boîtier (1), **caractérisé en ce que** le radiateur thermique interne est placé en contact thermique avec le ou les points chauds par l'intermédiaire d'au moins un collecteur de chaleur (40, 41) raccordé à au moins un conducteur thermique (42, 43) traversant des parois (44) du boîtier (1) et aboutissant à un ou des radiateurs thermiques externes (45).

2. Boîtier selon la revendication 1, **caractérisé en ce que** le ou les radiateurs thermiques internes (12, 13, 14) sont dimensionnés pour suffire au refroidissement de l'appareillage électrique placé dans le boîtier (1) en cas de fonctionnement normal de la ventilation forcée et **en ce que** le ou les radiateurs thermiques externes (45) sont dimensionnés pour compléter le refroidissement apporté par les radiateurs internes (12, 13, 14) en cas de perte de la ventilation forcée.

3. Boîtier selon la revendication 1, **caractérisé en ce qu'**une partie du flux d'air de la ventilation forcée est dirigée sur le ou les radiateurs thermiques externes (45).

4. Boîtier selon la revendication 1, **caractérisé en ce qu'**il comporte au moins une rampe interne (30) de distribution d'air pulsé parvenant au travers de ses parois (44), au niveau du ou des radiateurs thermiques externes (45).

5. Boîtier selon la revendication 1, comportant des modules amovibles plats (2, 3, 4) disposés dans une baie (1), côte à côte, sur la tranche, selon un ou des alignements perpendiculaires au fond (19) de la baie (1), **caractérisé en ce que** le ou les radiateurs thermiques externes (45) sont, fixées à l'extérieur, sur les tranches avant (44) des modules tournées vers le devant de la baie (1).

6. Boîtier selon la revendication 1, comportant des modules amovibles plats (2, 3, 4) disposés dans une baie (1), côte à côte, sur la tranche, selon un ou des alignements perpendiculaires au fond (19) de la baie (1), **caractérisé en ce que** le ou les radiateurs thermiques externes (45) sont placés dans une ou des cheminées (46) à ventilations naturelle et forcée, fixées à l'extérieur, sur les tranches avant (44) des modules (2, 3, 4) tournées vers le devant de la baie (1).

7. Boîtier selon la revendication 5, **caractérisé en ce qu'**un module (2, 3, 4) comporte au moins une rampe interne (30) de distribution d'air pulsé se prolongeant au travers de la paroi (44) du module (2, 3, 4) et assurant la ventilation forcée des différents radiateurs thermiques internes (12, 13, 14) et externes (45).

8. Boîtier selon la revendication 6, **caractérisé en ce qu'**un module (2, 3, 4) à cheminée externe (46) comporte une rampe interne (30) de distribution d'air pulsé se prolongeant au travers de la paroi (44) du module (2, 3, 4), assurant la ventilation forcée des radiateurs thermiques internes (12, 13, 14) et amplifiant le tirage de la cheminée externe (46).

9. Boîtier selon la revendication 6, **caractérisé en ce qu'**un module (2, 3, 4) à cheminée externe (46) comporte un ventilateur d'appoint (48) disposé à la base de la cheminée (46).

10. Boîtier selon la revendication 9, **caractérisé en ce qu'**un module (2, 3, 4) à cheminée externe (46) comporte, un ventilateur d'appoint (48) disposé à la base de la cheminée (46) et fonctionnant en cas de dépassement d'une température de consigne par le ou les radiateurs thermiques externes (45) logés dans la cheminée (46).

11. Boîtier selon la revendication 8, **caractérisé en ce qu'**un module (2, 3, 4) à cheminée externe (46) comporte, à la base de la cheminée (46), un ventilateur d'appoint (48) séparé par un cloisonnement, d'une chambre intercalaire (49) en communication avec la cheminée (46), dans laquelle débouche la rampe interne (30) de distribution d'air pulsé.

12. Boîtier selon la revendication 1, **caractérisé en ce que** le ou les conducteurs thermiques (42, 43) sont des caloducs.

13. Boîtier selon la revendication 1, **caractérisé en ce que** le ou les conducteurs thermiques (42, 43) sont des tiges à base de carbone à conductivité thermique élevée dans le sens longitudinal.

## Claims

1. An electronic device housing (1) that is cooled by natural ventilation, owing to the presence of ventilation holes in the panels of the housing, and by forced ventilation, using pulsed air, which device comprises at least one internal thermal radiator (12, 13, 14) that is cooled by natural and forced ventilation, in thermal contact with one or more hot spots of an electronic device that is located inside the housing (1), **characterised in that** the internal thermal radiator is brought into thermal contact with the one or more hot spots by means of at least one heat collector (40, 41) that is connected to at least one thermal conductor (42, 43) that passes through the panels (44) of the housing (1) and leads to one or more external thermal radiators (45).

2. The housing according to claim 1, **characterised in that** the one or more internal thermal radiators (12, 13, 14) are dimensioned such that they provide adequate cooling of the electronic device located inside the housing (1) during normal operation of the forced ventilation, and **in that** the one or more external thermal radiators (45) are dimensioned such that they complement the cooling provided by the internal radiators (12, 13, 14) in the event of a loss of the forced ventilation.

3. The housing according to claim 1, **characterised in that** part of the air flow of the forced ventilation is directed towards the one or more external thermal radiators (45).

4. The housing according to claim 1, **characterised in that** it comprises at least one internal distributor (30) for distributing pulsed air coming through its panels (44) to the one or more external thermal radiators (45).

5. The housing according to claim 1, comprising flat movable modules (2, 3, 4) arranged side-by-side in a bay (1) on an edge, in one or more perpendicular alignments on the base (19) of the bay (1), **characterised in that** the one or more external thermal radiators (45) are fixed to the outside on the front edges (44) of the modules that are turned towards the front of the bay (1).

6. The housing according to claim 1, comprising flat movable modules (2, 3, 4) arranged side-by-side in a bay (1) on an edge, in one or more perpendicular alignments on the base (19) of the bay (1), **characterised in that** the one or more external thermal radiators (45) are placed in one or more natural and forced ventilation ducts (46) that are fixed to the outside on the front edges (44) of the modules (2, 3, 4) that are turned towards the front of the bay (1).

7. The housing according to claim 5, **characterised in that** a module (2, 3, 4) comprises at least one internal distributor (30) for distributing pulsed air that extends through the panel (44) of the module (2, 3, 4) and provides the forced ventilation for the various internal (12, 13, 14) and external (45) thermal radiators.

8. The housing according to claim 6, **characterised in that** a module (2, 3, 4) with an external duct (46) comprises an internal distributor (30) for distributing pulsed air that extends through the panel (44) of the module (2, 3, 4), providing the forced ventilation for the internal thermal radiators (12, 13, 14) and amplifying the draw of the external duct (46).

9. The housing according to claim 6, **characterised in that** a module (2, 3, 4) with an external duct (46) comprises a booster fan (48) arranged on the base of the duct (46).

10. The housing according to claim 9, **characterised in that** a module (2, 3, 4) with an external duct (46) comprises a booster fan (48) that is arranged on the base of the duct (46) and that operates in the event that a set temperature is exceeded by the one or more external thermal radiators (45) housed in the duct (46).

11. The housing according to claim 8, **characterised in that** a module (2, 3, 4) with an external duct (46) comprises, at the base of the duct (46), a booster fan (48) that is separated by a partition from an intermediate chamber (49) that is linked to the duct (46) and which the internal distributor (30) for the distribution of pulsed air opens into.

12. The housing according to claim 1, **characterised in that** the one or more thermal conductors (42, 43) are heat pipes.

13. The housing according to claim 1, **characterised in that** the one or more thermal conductors (42, 43) are carbon-based rods with high thermal conductivity in the longitudinal direction.

## Patentansprüche

1. Gehäuse (1) für ein elektronisches Gerät, das durch natürliche Belüftung aufgrund der Anwesenheit von Lüftungslöchern in den Wänden des Gehäuses und durch Zwangsbelüftung mit Gebläseluft gekühlt wird, wobei das Gerät wenigstens einen durch natürliche und Zwangsbelüftung gekühlten internen Temperaturstrahler (12, 13, 14) in thermischem Kontakt mit einer oder mehreren heißen Stellen eines in dem Gehäuse (1) befindlichen elektronischen Gerätes aufweist, **dadurch gekennzeichnet, dass** der interne Temperaturstrahler mit Hilfe wenigstens eines Wärmekollektors (40, 41) mit den ein oder mehreren heißen Stellen in thermischen Kontakt gebracht wird, der mit wenigstens einem Wärmeleiter (42, 43) verbunden ist, der durch die Wände (44) des Gehäuses (1) verläuft und zu einem oder mehreren externen Temperaturstrahlern (45) führt.

2. Gehäuse nach Anspruch 1, **dadurch gekennzeichnet, dass** der oder die internen Temperaturstrahler (12, 13, 14) für eine ausreichende Kühlung des in dem Gehäuse (1) befindlichen elektronischen Gerätes bei normalem Betrieb der Zwangskühlung dimensioniert ist/sind, und dadurch, dass der oder die externen Temperaturstrahler (45) zum Ergänzen der von den internen Strahlern (12, 13, 14) bereitgestellten Kühlung im Fall eines Verlusts der Zwangsbelüftung dimensioniert ist/sind.

3. Gehäuse nach Anspruch 1, **dadurch gekennzeichnet, dass** ein Teil des Luftstroms der Zwangsbelüftung auf den oder die externen Temperaturstrahler (45) gerichtet wird.

4. Gehäuse nach Anspruch 1, **dadurch gekennzeichnet, dass** es wenigstens einen internen Verteiler (30) zum Verteilen von durch seine Wände (44) kommender Gebläseluft zu den ein oder mehreren externen Temperaturstrahlern (45) umfasst.

5. Gehäuse nach Anspruch 1, das flache herausnehmbare Module (2, 3, 4) umfasst, die in einem Rahmen (1) nebeneinander auf dem Rand stehend in einer oder mehreren lotrechten Ausrichtungen auf dem Boden (19) des Rahmens (1) angeordnet sind, **dadurch gekennzeichnet, dass** der oder die externe(n) Temperaturstrahler (45) auf der Außenseite an den vorderen Rändern (44) der Module befestigt sind, die zur Vorderseite des Rahmens (1) hin gedreht sind.

6. Gehäuse nach Anspruch 1, das flache herausnehmbare Module (2, 3, 4) umfasst, die in einem Rahmen (1) nebeneinander auf dem Rand stehend in einer oder mehreren lotrechten Ausrichtungen am Boden (19) des Rahmens (1) angeordnet sind, **dadurch gekennzeichnet, dass** der oder die externe(n) Temperaturstrahler (45) in einem oder mehreren natürlichen und Zwangsbelüftungsabzugsschloten (46) platziert sind, die an der Außenseite auf den vorderen Rändern (44) der Module (2, 3, 4) befestigt sind, die zur Vorderseite des Rahmens (1) hin gedreht sind.

7. Gehäuse nach Anspruch 5, **dadurch gekennzeichnet, dass** ein Modul (2, 3, 4) wenigstens einen internen Verteiler (30) zum Verteilen von Gebläseluft umfasst, der durch die Wand (44) des Moduls (2, 3, 4) verläuft und die Zwangsbelüftung für die verschiedenen internen (12, 13, 14) und externen (45) Temperaturstrahler bereitstellt.

8. Gehäuse nach Anspruch 6, **dadurch gekennzeichnet, dass** ein Modul (2, 3, 4) mit einem externen Abzugsschlot (46) einen internen Verteiler (30) zum Verteilen von Gebläseluft umfasst, der durch die Wand (44) des Moduls (2, 3, 4) verläuft und die Zwangsbelüftung für die internen Temperaturstrahler (12, 13, 14) gewährleistet und den Abzug des externen Abzugsschlots (46) verstärkt.

9. Gehäuse nach Anspruch 6, **dadurch gekennzeichnet, dass** ein Modul (2, 3, 4) mit einem externen Abzugsschlot (46) ein Zusatzgebläse (48) umfasst, das an der Basis des Abzugsschlots (46) angeordnet ist.

10. Gehäuse nach Anspruch 9, **dadurch gekennzeichnet, dass** ein Modul (2, 3, 4) mit einem externen Abzugsschlot (46) ein Zusatzgebläse (48) umfasst, das an der Basis des Abzugsschlots (46) angeordnet ist und in dem Fall arbeitet, dass eine Solltemperatur von dem oder den im Abzugsschlot (46) aufgenommenen externen Temperaturstrahler(n) (45) überschritten wird.

11. Gehäuse nach Anspruch 8, **dadurch gekennzeichnet, dass** ein Modul (2, 3, 4) mit einem externen Abzugsschlot (46) an der Basis des Abzugsschlots (46) ein Zusatzgebläse (48) umfasst, das durch eine Abtrennung von einer Zwischenkammer (49) getrennt wird, die mit dem Abzugsschlot (46) in Verbindung ist und in die der interne Verteiler (30) zum Verteilen von Gebläseluft mündet.

12. Gehäuse nach Anspruch 1, **dadurch gekennzeichnet, dass** der oder die Wärmeleiter (42, 43) Wärmerohre ist/sind.

13. Gehäuse nach Anspruch 1, **dadurch gekennzeichnet, dass** der oder die Wärmeleiter (42, 43) Kohlenstoffstäbe mit hoher Wärmeleitfähigkeit in der Längsrichtung sind.
